(19) **Europäisches Patentamt**
**European Patent Office**
**Office européen des brevets**

(11) **EP 2 148 240 B1**

(12) **EUROPEAN PATENT SPECIFICATION**

(45) Date of publication and mention of the grant of the patent:
**25.02.2015 Bulletin 2015/09**

(51) Int Cl.:
*C23C 14/08* (2006.01)   *H01B 5/14* (2006.01)
*H01B 13/00* (2006.01)   *G02F 1/1343* (2006.01)
*G02B 1/11* (2015.01)

(21) Application number: **08752975.6**

(22) Date of filing: **20.05.2008**

(86) International application number:
**PCT/JP2008/059179**

(87) International publication number:
**WO 2008/143232 (27.11.2008 Gazette 2008/48)**

(54) **TRANSPARENT ELECTRODE**

TRANSPARENTE ELEKTRODE

ÉLECTRODE TRANSPARENTE

(84) Designated Contracting States:
**AT BE BG CH CY CZ DE DK EE ES FI FR GB GR HR HU IE IS IT LI LT LU LV MC MT NL NO PL PT RO SE SI SK TR**

(30) Priority: **22.05.2007 JP 2007135336**

(43) Date of publication of application:
**27.01.2010 Bulletin 2010/04**

(73) Proprietor: **Nippon Electric Glass Co., Ltd.**
**Otsu-shi**
**Shiga 520-8639 (JP)**

(72) Inventors:
• **IMURA, Masaaki**
**Otsu-shi**
**Shiga 520-8639 (JP)**

• **KUBOSAKA, Mamoru**
**Otsu-shi**
**Shiga 520-8639 (JP)**
• **KANAI, Toshimasa**
**Otsu-shi**
**Shiga 520-8639 (JP)**

(74) Representative: **Tetzner, Michael et al**
**TETZNER & PARTNER mbB**
**Patent- und Rechtsanwälte**
**Van-Gogh-Strasse 3**
**81479 München (DE)**

(56) References cited:
**GB-A- 2 432 222       JP-A- 03 504 900**
**JP-A- 08 188 871       JP-A- 62 227 082**
**JP-A- 63 103 060       JP-A- 2001 059 157**
**JP-A- 2005 508 569     US-A1- 2005 030 629**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

**Description**

TECHNICAL FIELD

This invention relates to transparent electrodes that are excellent in transmittance in the infrared wavelength range and are used in optical communication devices mainly using infrared light.

BACKGROUND ART

In recent years, tunable filters and tunable lasers combined with liquid crystal have been developed as a form of optical communication device using infrared light, particularly infrared light near 1.55 $\mu$m. These devices use a transparent electrode including an ITO thin film or the like, and can change the refractive index of liquid crystal by applying a voltage to the transparent electrode, thereby changing the passband wavelength of the filter or the laser wavelength (see for example JP 2000 514566 A).

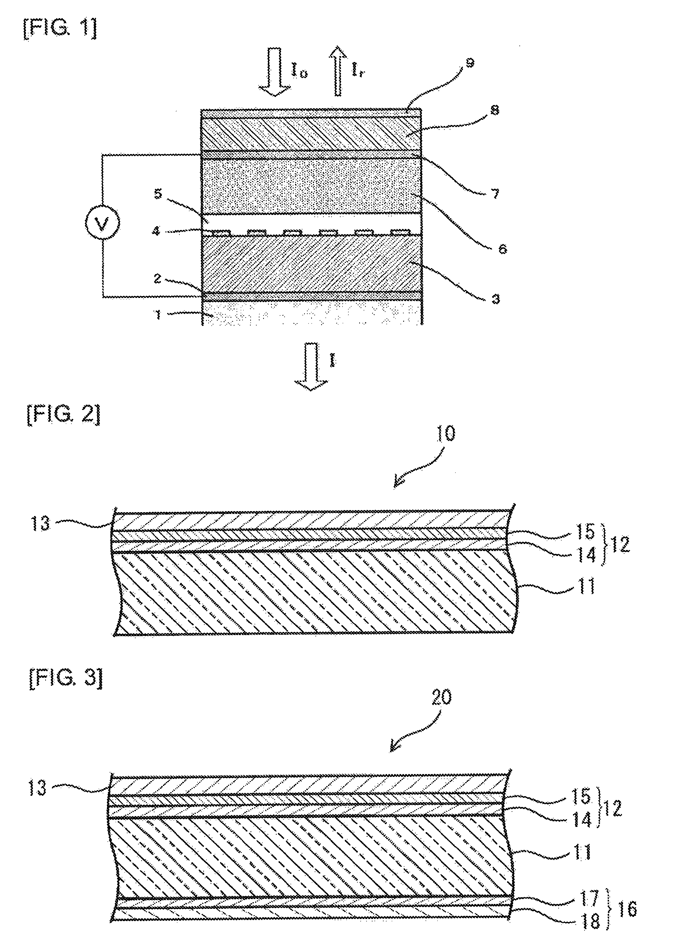

FIG. 1 is a schematic view illustrating an example of a tunable filter. The tunable filter is configured, as shown in FIG. 1, so that an opposed electrode 2, a coating layer 3 made of material such as $SiO_2$, a grating 4 likewise made of material such as $SiO_2$, a waveguide 5 made of material such as $Si_3N_x$, a liquid crystal layer 6, a transparent conductive film 7, a transparent substrate 8 such as a glass substrate, and if required an antireflection film 9 are formed in this order on a substrate 1 having a high infrared light transmittance, such as a silicon wafer. Incident light $I_o$ having entered the tunable filter from above transmits through the layers. Meanwhile, only part of the light $I_r$ having a particular wavelength is reflected from the grating 4 surface, resonates in the waveguide 5 and is then filtered out of the incident light side of the filter. The rest of the light having other wavelengths transmits through and out of the filter from the transparent substrate 1 side without reflecting off the grating 4 surface. In this case, when a voltage is applied between the transparent conductive film 7 and the opposed electrode 2, the refractive index of the liquid crystal layer 6 changes, whereby the wavelength of reflected light $I_r$ to be filtered out can be controlled.

DISCLOSURE OF THE INVENTION

A transparent electrode having such a transparent conductive film, particularly a transparent conductive film made of an ITO thin film, has a high electric conductivity and, therefore, is suitably used in a liquid crystal display, such as an FPD. However, when the transparent electrode is used in the infrared wavelength range, it significantly absorbs light owing to its electric conductivity. In other words, the transparent electrode has a problem in that in the infrared wavelength range it has a large extinction coefficient and causes a high optical loss.

The extinction coefficient is defined as follows. Specifically, when a substance absorbs light, transmitted light I attenuates according to the following relation using the intensity of incident light $I_o$ and the light penetration depth Z

$$I = I_o e^{-\alpha z}$$

Here, $\alpha$ indicating the attenuation per unit length is referred to as the absorption coefficient. On the other hand, in theoretically determining the interaction between light and the substance, reference is made to the amount of light absorption per oscillation frequency in the electromagnetic field. Therefore, the extinction coefficient k is defined as an amount for defining the light absorption of the substance. The following relation exists between the extinction coefficient k, the absorption coefficient $\alpha$ and the wavelength $\lambda$.

$$k = \alpha \times \lambda/4\pi$$

GB 2 432 222 A discloses transparent electrodes having a transparent conductive film made of indium titanium oxide and indium tin oxide, wherein in the examples the transparent conductive films exhibit extinction coefficients at a wavelength of 1.55 $\mu$m of 0.035 to 0.240 for the inventive indium titanium oxide examples and 0.256 and 0.310 for comparative indium tin oxide examples.

An object of the present invention is to provide a transparent electrode that is used in an optical communication device using infrared light, particularly infrared light near 1.55 $\mu$m, and has a small extinction coefficient for infrared light and a high infrared light transmittance.

The inventors have found from various studies that the above problem can be solved by using, as a transparent conductive film used in a transparent electrode, a film having a high light transmittance in the infrared wavelength range, and propose the transparent electrode as the present invention.

Specifically, a transparent electrode according to the present invention includes a transparent conductive film, wherein the extinction coefficient of the transparent conductive film at a wavelength of 1.55 $\mu$m is equal to or less than 0.01. As described above, the transmittance at a wavelength of 1.55 $\mu$m is important for optical communication devices using infrared light. Since in this invention the extinction coefficient at that wavelength is equal to or less than 0.01, the loss of transmitted light can be reduced, which makes it possible to provide a transparent electrode having a high infrared light transmittance.

Examples of the transparent conductive film include a film made of indium tin oxide (ITO). ITO has a high electric conductivity and, therefore, makes it possible to provide a transparent electrode suitable for optical communication devices using infrared light, such as tunable filters and tunable lasers as described above.

Examples of the transparent conductive film also include a film made of indium titanium oxide (ITiO).

The transparent conductive film is preferably deposited by a sputtering process in an atmosphere satisfying the condition that the ratio of the flow rate of $O_2$ gas to the flow rate of rare gas is equal to or greater than $3.0 \times 10^{-3}$.

The transparent conductive film is preferably deposited by a sputtering process in an atmosphere satisfying the condition that the ratio of the flow rate of $O_2$ gas to the flow rate of rare gas is equal to or greater than $5.0 \times 10^{-3}$.

If the transparent conductive film is made of indium tin oxide, it is more preferably deposited by a sputtering process in an atmosphere satisfying the condition that the ratio of the flow rate of $O_2$ gas to the flow rate of rare gas is equal to or greater than $4.0 \times 10^{-3}$.

If the transparent conductive film is made of indium titanium oxide, it is more preferably deposited by a sputtering process in an atmosphere satisfying the condition that the ratio of the flow rate of $O_2$ gas to the flow rate of rare gas is equal to or greater than $10.0 \times 10^{-3}$.

The geometric thickness of the transparent conductive film is preferably 5 to 200 nm.

The sheet resistance of the transparent conductive film is preferably 500 $\Omega$/sq. or more. If the sheet resistance meets the above range, the transparent electrode can have a high transmittance at a wavelength of 1.55 $\mu$m.

The transparent conductive film may be formed on a substrate.

The transparent electrode according to the present invention may include an antireflection film. When the transparent electrode includes an antireflection film together with a transparent conductive film, this provides suppression of reflection of incident light and, therefore, can increase the infrared light transmittance of the transparent electrode.

Antireflection films are preferably formed on both the front and back sides of the substrate.

The transparent conductive film is preferably formed on the antireflection film formed on the front side of the substrate.

The antireflection film is preferably a stacked film composed of a low-refractive index layer and a high-refractive index layer. If the antireflection film has the above film structure, the transparent electrode can be given an excellent antireflection property, which further increases the infrared light transmittance of the transparent electrode.

The transparent electrode of the present invention can be used in an optical communication device using infrared light, such as a tunable filter or a tunable laser.

A method for producing a transparent conductive film according to the present invention includes depositing a transparent conductive film by use of a sputtering process in a sputtering atmosphere satisfying the condition that the ratio of the flow rate of $O_2$ gas to the flow rate of rare gas is equal to or greater than $3.0 \times 10^{-3}$. By controlling the ratio of the flow rates of rare gas and $O_2$ gas at the predetermined ratio in depositing a transparent conductive film by a sputtering process, a transparent conductive film of small extinction coefficient and high infrared light transmittance can be provided.

The sputtering atmosphere preferably satisfies the condition that the ratio of the flow rate of $O_2$ gas to the flow rate of rare gas is equal to or greater than $5.0 \times 10^{-3}$.

(Effects of the Invention)

According to the transparent electrode of the present invention, the transparent conductive film constituting part of the transparent electrode has a low extinction coefficient. Therefore, the loss of transmitted light can be reduced, which makes it possible to provide a transparent electrode having a high infrared light transmittance. Hence, the transparent electrode of the present invention is suitable for optical communication devices using infrared light, such as tunable filters and tunable lasers.

BRIEF DESCRIPTION OF THE DRAWINGS

[FIG. 1] FIG. 1 is a schematic cross-sectional view illustrating an example of a tunable filter.

[FIG. 2] FIG. 2 is a cross-sectional view of a transparent electrode according to an embodiment.

[FIG. 3] FIG. 3 is a cross-sectional view of a transparent electrode according to another embodiment.

[FIG. 4] FIG. 4 is a graph showing results of measurement of extinction coefficient when a transparent conductive film is an ITO film.

[FIG. 5] FIG. 5 is a graph showing results of measurement of extinction coefficient when a transparent conductive film is an ITiO film.

List of Reference Numerals

| 1 | substrate |
| 2 | opposed electrode |
| 3 | coating layer |
| 4 | grating |
| 5 | waveguide |
| 6 | liquid crystal layer |
| 7 | transparent conductive film |
| 8 | transparent substrate |
| 9 | antireflection film |
| 10 | transparent electrode |
| 11 | substrate |
| 12 | antireflection film |
| 13 | transparent conductive film |
| 14 | low-refractive index layer |
| 15 | high-refractive index layer |
| 16 | antireflection film |
| 17 | low-refractive index layer |
| 18 | high-refractive index layer |

BEST MODE FOR CARRYING OUT THE INVENTION

FIG. 2 is a cross-sectional view of a transparent electrode 10 according to an embodiment. As shown in FIG. 2, the transparent electrode 10 includes a substrate 11, an antireflection film 12 formed on the substrate 11, and a transparent conductive film 13 formed on the antireflection film 12.

The extinction coefficient of the transparent conductive film 13 at a wavelength of 1.55 $\mu$m is equal to or less than 0.01, and preferably equal to or less than 0.005. If the extinction coefficient of the transparent conductive film 13 is above 0.01, the loss of transmitted infrared light is large, whereby the transparent electrode 10 tends to be unsuitable for infrared light devices. The lower limit of the extinction coefficient of the transparent conductive film 13 is not particularly limited, but is actually equal to or greater than 0.0001. The extinction coefficient of the transparent conductive film 13 preferably satisfies the above region of values over the whole wavelength range of 1.5 to 1.6 $\mu$m. In such a case, the transparent electrode 10 is more suitably used as an infrared optical communication device.

The resistivity of the transparent conductive film 13 is not particularly limited. However, if the resistivity of the transparent conductive film 13 is too low, the extinction coefficient thereof at a wavelength of 1.55 $\mu$m tends to be large. Therefore, the resistivity of the transparent conductive film 13 is preferably $10^3$ $\mu\Omega\cdot$cm or more, and more preferably $10^4$ $\mu\Omega\cdot$cm or more. On the other hand, if the resistivity of the transparent conductive film 13 is too high, the electric conductivity of the transparent conductive film 13 tends to be low and the transparent electrode 10 tends to be unsuitable particularly for optical communication devices. Therefore, the resistivity of the transparent conductive film 13 is preferably $10^5$ $\mu\Omega\cdot$cm or less.

The extinction coefficient and resistivity of the transparent conductive film 13 can be controlled, for example, by suitably changing the ratio of the flow rates of gases in depositing the transparent conductive film 13 by a sputtering process. More specifically, the extinction coefficient and resistivity of the transparent conductive film 13 can be controlled, as will be described later, by suitably changing the ratio of the flow rates of $O_2$ gas to rare gas.

The geometric thickness of the transparent conductive film 13 is preferably 5 to 200 nm, more preferably 10 to 100 nm, still more preferably 10 to 50 nm, and most preferably 10 to 30 nm. If the geometric thickness of the transparent conductive film 13 is smaller than 5 nm, the sheet resistance of the transparent conductive film 13 is high, resulting in the tendency of the transparent electrode 10 to be unsuitable for optical communication devices, and the transparent conductive film 13 tends to become difficult to deposit. On the other hand, if the geometric thickness of the transparent conductive film 13 is larger than 200 nm, the transmittance of the transparent conductive film 13 at a wavelength of 1.55 $\mu$m tends to be low.

The sheet resistance of the transparent conductive film 13 is preferably 500 $\Omega$/sq. or more, more preferably 1 k$\Omega$/sq. or more, still more preferably 2 k$\Omega$/sq. or more, and most preferably 5 k$\Omega$/sq. or more. If the sheet resistance of the transparent conductive film 13 is lower than 500 $\Omega$/sq., the transmittance of the transparent conductive film 13 at a wavelength of 1.55 $\mu$m tends to be low. The upper limit of the sheet resistance of the transparent conductive film 13 is not particularly limited. However, if the sheet resistance of the transparent conductive film 13 is too high, a sufficient electric field cannot be applied to the liquid crystal or the like and the device tends to malfunction. Therefore, the sheet resistance of the transparent conductive film 13 is preferably 50 k$\Omega$/sq. or less. Note that there exists the relation that the sheet resistance is equal to the resistivity divided by the film thickness.

Examples of the transparent conductive film 13 used include an ITO film, an indium titanium oxide (ITiO) film, an aluminium-doped zinc oxide (AZO) film, a germanium-doped zinc oxide (GZO) film, an indium zinc oxide (IZO) film, and antimony-doped tin oxide (ATO) film. Among them, the use of an ITO film or an ITiO film is preferable because of their high electric conductivity and suitability for infrared optical communication devices, and the use of an ITiO film is particularly preferable.

The material for the substrate 11 is not particularly limited so far as it has a high transmittance in the infrared wavelength range. For example, use can be made of a transparent substrate, such as a glass substrate, a plastic substrate or a silicon substrate. From the viewpoints of environment resistance, heat resistance, light resistance and the like, the substrate 11 is preferably formed of a glass substrate.

In the transparent electrode 10 are formed the antireflection film 12 together with the transparent conductive film 13. Therefore, the reflection of infrared light is suppressed, which increases the infrared light transmittance of the transparent electrode 10.

The antireflection film 12 is preferably a stacked film composed of a high-refractive index layer 14 and a low-refractive index layer 15. Suitable materials for forming the low-refractive index layer 15 include $SiO_2$ and fluorides such as $MgF_2$, all of which have a refractive index of 1.6 or less at a wavelength of 1.55 $\mu$m. Suitable materials for forming the high-refractive index layer 14 include $Nb_2O_5$, $TiO_2$, $Ta_2O_5$, $HfO_2$, $ZrO_2$ and Si, all of which have a refractive index of 1.6 or more.

The geometric thickness of the antireflection film 12 is not particularly limited, but is generally suitably controlled within the range from 5 to 500 nm. If the geometric thickness of the antireflection film 12 is less than 5 nm, the transparent electrode 10 is less likely to be given a sufficient antireflection function and the antireflection film 12 tends to become difficult to deposit. If the geometric thickness of the antireflection film 12 is above 500 nm, the surface roughness of the antireflection film 12 is large, which makes it easy to scatter light and cause problems of peeling and warpage.

If not only the transparent conductive film 13 is formed on the substrate 11 but also an antireflection film is formed on the back side of the substrate 11, the infrared light transmittance can be still further increased.

The transparent electrode 10 has a small extinction coefficient at a wavelength of 1.55 $\mu$m as described previously and, therefore, has a high transmittance. For this reason, the transparent electrode 10 is suitably used for infrared light devices. The transmittance of the transparent electrode 10 at a wavelength of 1.55 $\mu$m is preferably 92% or more, more preferably 95% or more, and still more preferably 98% or more. If the transmittance of the transparent electrode 10 at a wavelength of 1.55 $\mu$m is less than 92%, the transparent electrode 10 tends to be unsuitable for infrared light devices. The transmittance of the transparent electrode 10 preferably satisfies the above region of values over the whole wavelength range of 1.5 to 1.6 $\mu$m. In such a case, the transparent electrode 10 is more suitable as an infrared optical communication device. Note that the term "transmittance" here refers to the transmittance of the entire layered structure.

When in an infrared light device the transparent electrode 10 is used with the transparent conductive film 13 in contact with liquid crystal, an orientation film, such as a polyimide film, is preferably formed between the liquid crystal and the transparent conductive film 13. The thickness of the orientation film is not particularly limited, but is generally controlled within the range from 10 to 50 nm.

The method for depositing the transparent conductive film 13 is not particularly limited, and known deposition methods can be applied. Among them, sputtering deposition is preferable because the resultant transparent conductive film 13 is excellent in adhesiveness, strength and smoothness.

The deposition of the transparent conductive film 13 by a sputtering process using a sputtering target is generally performed under an atmosphere of a mixed gas containing rare gas and $O_2$ gas. In this case, the flow rate of rare gas and the flow rate of $O_2$ gas are set to satisfy the condition that the ratio of the flow rate of $O_2$ gas to the flow rate of rare gas is equal to or greater than $3.0 \times 10^{-3}$, preferably set to satisfy the condition that the ratio of the flow rate of $O_2$ gas to the flow rate of rare gas is equal to or greater than $5.0 \times 10^{-3}$, and more preferably set to satisfy the condition that the ratio of the flow rate of $O_2$ gas to the flow rate of rare gas is equal to or greater than $10.0 \times 10^{-3}$. If the ratio of the flow rate of $O_2$ gas to the flow rate of rare gas is less than $3.0 \times 10^{-3}$, the resistivity of the transparent conductive film 13 tends to be low and, as a result, the extinction coefficient thereof at a wavelength of 1.55 $\mu$m is likely to be large.

If the transparent conductive film 13 is made of indium tin oxide, it is more preferably deposited by a sputtering process in an atmosphere satisfying the condition that the ratio of the flow rate of $O_2$ gas to the flow rate of rare gas is equal to or greater than $4.0 \times 10^{-3}$.

If the transparent conductive film 13 is made of indium titanium oxide, it is more preferably deposited by a sputtering process in an atmosphere satisfying the condition that the ratio of the flow rate of $O_2$ gas to the flow rate of rare gas is equal to or greater than $10.0 \times 10^{-3}$.

The upper limit of the ratio of the flow rate of $O_2$ gas to the flow rate of rare gas is not particularly limited. However, if the ratio of the flow rate of $O_2$ gas to the flow rate of rare gas is too high, the resistivity of the transparent conductive film 13 is high, which makes the transparent electrode 10 unsuitable for infrared optical communication devices. Therefore, the ratio of the flow rate of $O_2$ gas to the flow rate of rare gas is preferably $20 \times 10^{-3}$ or less.

Argon is preferably used as rare gas because of its low price.

The temperature of the substrate 11 in deposition by a sputtering process is not particularly limited. However, if the temperature of the substrate 11 is too high, the extinction coefficient of the transparent conductive film 13 at a wavelength of 1.55 $\mu$m tends to be large. Therefore, the temperature of the substrate 11 is preferably 400°C or less, and more preferably 300°C or less.

(Other Embodiments)

FIG. 3 is a cross-sectional view of a transparent electrode 20 according to another embodiment. As shown in FIG. 3, it is preferable, in addition to the formation of the antireflection film 12 on the front side of the substrate 11, to form an antireflection film 16 also on the back side of the substrate 11. Thus, the reflection of infrared light can be further suppressed to further increase the infrared light transmittance of the transparent electrode 20.

The antireflection film 16 is preferably a stacked film composed of a high-refractive index layer 17 and a low-refractive index layer 18. Suitable materials for forming the low-refractive index layer 18 include $SiO_2$ and fluorides such as $MgF_2$, all of which have a refractive index of 1.6 or less at a wavelength of 1.55 $\mu$m. Suitable materials for forming the high-refractive index layer 17 include $Nb_2O_5$, $TiO_2$, $Ta_2O_5$, $HfO_2$, $ZrO_2$ and Si, all of which have a refractive index of 1.6 or more.

(Examples)

Hereinafter, the present invention will be described in detail with reference to examples, but is not limited to the examples.

As shown in Table 1, transparent conductive films of ITO films were formed by sputtering on glass substrates (OA-10, manufactured by Nippon Electric Glass Co., Ltd., refractive index: 1.47, thickness: 1.1 mm).

In these cases, the deposition of ITO films in Examples 1 to 5 and Comparative Example 1 was conducted using a DC sputtering apparatus. The deposition conditions were as follows: a sputtering gas was first introduced into the apparatus with the interior under a high vacuum of up to $5 \times 10^{-4}$ Pa at the flow rates of gases described in Table 1, and then sputtering was performed at a pressure of 0.1 Pa, a power of 1800 W and a substrate temperature of 250°C.

The extinction coefficients of the ITO films formed in Examples 1 to 5 and Comparative Example 1 were measured with a spectroscopic ellipsometer manufactured by J. A. Woollam Co., Inc. Furthermore, the sheet resistances of the ITO films were measured with Loresta manufactured by Mitsubishi Chemical Analytech Co., Ltd. The resistivities were calculated from the relation between sheet resistance and film thickness. In addition, the transmittances were determined from the simulation where each transparent electrode, in which an ITO film, a polyimide orientation film, and in some cases a stacked film serving as an antireflection film and composed of a $SiO_2$ film (refractive index at 1.55 $\mu$m wavelength (the same applies hereinafter) = 1.46) and a $Nb_2O_5$ film (refractive index = 2.26) were formed in the order and thicknesses described in Table 1, was subjected to incidence of light of 1.55 $\mu$m wavelength from the orientation film side. The results are shown in Table 1.

[Table 1]

| | | Example | | | | | Comp. Example |
|---|---|---|---|---|---|---|---|
| | | 1 | 2 | 3 | 4 | 5 | 1 |
| 4th Layer | | - | - | - | Orientation Film (30nm) | Orientation Film (30nm) | - |
| 3rd Layer | | - | - | - | ITO (15nm) | ITO (15nm) | - |

(continued)

| | Example | | | | | Comp. Example |
| | 1 | 2 | 3 | 4 | 5 | 1 |
|---|---|---|---|---|---|---|
| 2nd Layer | Orientation Film (30nm) | Orientation Film (30nm) | Orientation Film (30nm) | $SiO_2$ (183nm) | $SiO_2$ (183nm) | Orientation Film (30nm) |
| 1st Layer | ITO (15nm) | ITO (15nm) | ITO (15nm) | $Nb_2O_5$ (10nm) | $Nb_2O_5$ (10nm) | ITO (15nm) |
| Substrate | Glass Substrate | | | | | |
| 1st Layer on the Back | - | - | - | - | $Nb_2O_5$ (49nm) | - |
| 2nd Layer on the Back | - | - | - | - | $SiO_2$ (351nm) | - |
| $O_2$ Flow Rate (SCCM) | 1.7 | 2 | 6 | 6 | 6 | 1 |
| Ar Flow Rate (SCCM) | 500 | 500 | 500 | 500 | 500 | 500 |
| $O_2$ Flow Rate / Ar Flow Rate ($\times 10^{-3}$) | 3.4 | 4.0 | 12.0 | 12.0 | 12.0 | 2.0 |
| Extinction Coefficient | 0.41 | 0.02 | 0.002 | 0.002 | 0.002 | 0.65 |
| Resistivity ($\mu\Omega\cdot$cm) | $1.0 \times 10^3$ | $2.1 \times 10^3$ | $1.2 \times 10^4$ | $1.2 \times 10^4$ | $1.2 \times 10^4$ | $5.7 \times 10^2$ |
| Sheet Resistance ($\Omega$/sq.) | 700 | 1400 | 8000 | 8000 | 8000 | 380 |
| Transmittance(%) | 93.3 | 95.6 | 95.7 | 95.8 | $\fallingdotseq$100 | 91.3 |

It is obvious from Table 1 that in the transparent electrodes of Examples 3 to 5 (inventive) the transparent conductive films constituting parts of them have low extinction coefficients at a wavelength of 1.55 $\mu$m and, therefore, the transparent electrodes have high transmittances. On the other hand, Table 1 shows that in the transparent electrode of Examples 1 and 2 (not part of the invention) and Comparative Example 1 the transparent conductive film has a very large extinction coefficient at a wavelength of 1.55 $\mu$m and, therefore, the transparent electrode has a low transmittance.

Furthermore, as shown in Table 2, Examples 6 and 7 were produced in which the flow rates of oxygen during deposition of ITO films were different from those in Examples 1 to 5.

Moreover, transparent electrodes having the layered structures shown in Table 3 were also produced as Examples 8 to 17 by forming ITiO films as transparent conductive films on glass substrates (OA-10, manufactured by Nippon Electric Glass Co., Ltd., refractive index: 1.47, thickness: 1.1 mm). The deposition of ITiO films was conducted using a DC sputtering apparatus. The deposition conditions were as follows: a sputtering gas was first introduced into the apparatus with the interior under a high vacuum of up to 5 x $10^{-4}$ Pa at the flow rates of gases described in Table 1, and then sputtering was performed at a pressure of 0.1 Pa, a power of 1800 W and a substrate temperature of 250°C.

Also for Examples 8 to 17, the extinction coefficients and sheet resistances of the ITiO films were measured in the same manner as for Examples 1 to 5, and the resistivities thereof were calculated in the same manner as for Examples 1 to 5. In addition, the transmittances were simulated.

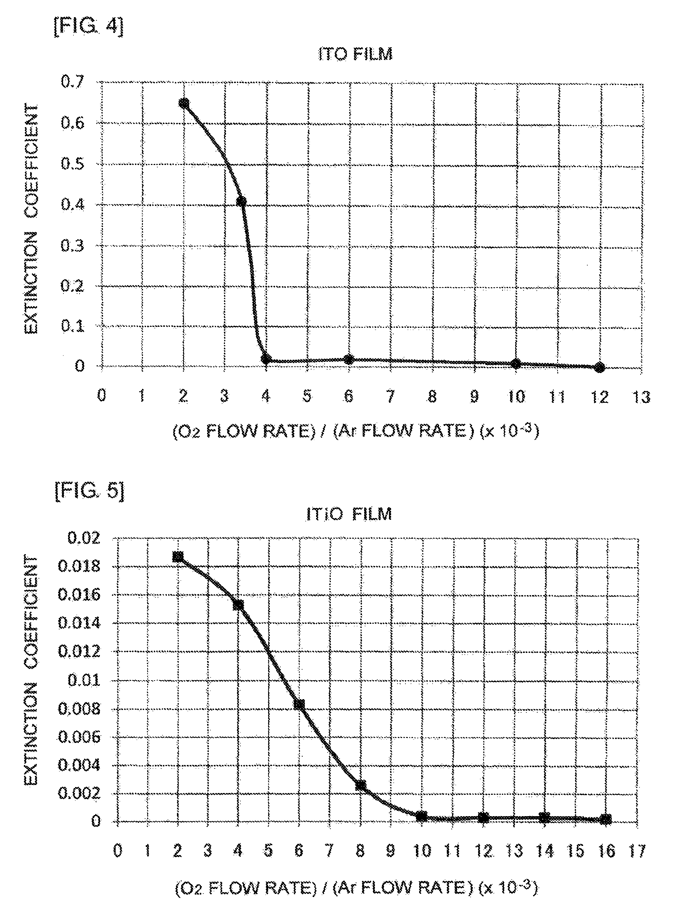

The results for Examples 6 to 17 (inventive), together with the results for Examples 3 to 5 (inventive), Examples 1 and 2 (not part of the invention) and Comparative Example 1, are shown in Table 2, Table 3, FIG. 4 and FIG. 5.

[Table 2]

| | Example 1 | Example 2 | Example 6 | Example 7 | Example 3 | Example 4 | Example 5 | Comp. Ex. 1 |
|---|---|---|---|---|---|---|---|---|
| 4th Layer | - | - | - | - | - | Orientation Film (30nm) | Orientation Film (30nm) | - |
| 3rd Layer | - | - | - | - | - | ITO | ITO | - |
| 2nd Layer | Orientation Film (30nm) | Orientation Film (30nm) | Orientation Film (30nm) | Orientation Film (30nm) | Orientation Film (30nm) | $SiO_2$ (183nm) | $SiO_2$ (183nm) | Orientation Film (30nm) |
| 1st Layer | ITO (15nm) | ITO (15nm) | ITO (15nm) | ITO (15nm) | ITO (15nm) | $Nb_2O_5$ (10nm) | $Nb_2O_5$ (10nm) | ITO (15nm) |
| Substrate | Glass Substrate | | | | | | | |
| 1st Layer on the Back | - | - | - | - | - | - | $Nb_2O_5$ (49nm) | - |
| 2nd Layer on the Back | - | - | - | - | - | - | $SiO_2$ (351 nm) | - |
| $O_2$ Flow Rate (SCCM) | 1.7 | 2 | 3 | 5 | 6 | 6 | 6 | 1 |
| Ar Flow Rate (SCCM) | 500 | 500 | 500 | 500 | 500 | 500 | 500 | 500 |
| $O_2$ Flow Rate /Ar Flow Rate ($\times 10^{-3}$) | 3.4 | 4 | 6 | 10 | 12 | 12 | 12 | 2 |
| Extinction Coefficient | 0.41 | 0.02 | 0.02 | 0.01 | 0.002 | 0.002 | 0.002 | 0.65 |
| Resistivity ($\mu\Omega\cdot$cm) | $1.0\times10^3$ | $2.1\times10^3$ | $3.3\times10^3$ | $4.8\times10^3$ | $1.2\times10^4$ | $1.2\times10^4$ | $1.2\times10^4$ | $5.7\times10^2$ |
| Sheet Resistance ($\Omega$/sq.) | 700 | 1400 | 2200 | 3200 | 8000 | 8000 | 8000 | 380 |
| Transmittance (%) | 93.30 | 95.55 | 95.59 | 95.63 | 95.66 | 95.76 | ≒100 | 91.35 |

[Table 3]

| | Example | | | | | | | | | | |
|---|---|---|---|---|---|---|---|---|---|---|---|
| | 8 | 9 | 10 | 11 | 12 | 13 | 14 | 15 | 16 | 17 |
| 4th Layer | - | - | - | - | - | - | - | - | Orientation Film (30nm) | Orientation Film (30nm) |
| 3rd Layer | - | - | - | - | - | - | - | - | ITiO (15nm) | ITiO (15nm) |
| 2nd Layer | Orientation Film (30nm) | Orientation Film (30nm) | Orientation Film (30nm) | Orientation Film (30nm) | Orientation Film (30nm) | Orientation Film (30nm) | Orientation Film (30nm) | Orientation Film (30nm) | $SiO_2$ (181nm) | $SiO_2$ (181nm) |
| 1st Layer | ITiO (15nm) | ITiO (15nm) | ITiO (15nm) | ITiO (15nm) | ITiO (15nm) | ITiO (15nm) | ITiO (15nm) | ITiO (15nm) | $Nb_2O_5$ (10nm) | $Nb_2O_5$ (10nm) |
| Substrate | Glass Substrate | | | | | | | | | |
| 1st Layer on the Back | - | - | - | - | - | - | - | - | - | $Nb_2O_5$ (49nm) |
| 2nd Layer on the Back | - | - | - | - | - | - | - | - | - | $SiO_2$ (351nm) |
| $O_2$ Flow Rate (SCCM) | 1 | 2 | 3 | 4 | 5 | 6 | 7 | 8 | 6 | 6 |
| Ar Flow Rate (SCCM) | 500 | 500 | 500 | 500 | 500 | 500 | 500 | 500 | 500 | 500 |
| $O_2$ Flow Rate /Ar Flow Rate ($\times 10^{-3}$) | 2 | 4 | 6 | 8 | 10 | 12 | 14 | 16 | 12 | 12 |
| Extinction Coefficient | 0.0187 | 0.0153 | 0.0083 | 0.0026 | 0.0004 | 0.0003 | 0.0003 | 0.0002 | 0.0003 | 0.0003 |
| Resistivity ($\mu\Omega\cdot$cm) | $0.6\times 10^3$ | $0.7\times 10^3$ | $1.0\times 10^3$ | $1.3\times 10^3$ | $1.6\times 10^3$ | $2.1\times 10^3$ | $3.3\times 10^3$ | $5.9\times 10^3$ | $2.1\times 10^3$ | $2.1\times 10^3$ |
| Sheet Resistance ($\Omega$/sq.) | 400 | 500 | 700 | 900 | 1000 | 1400 | 2200 | 4000 | 1400 | 1400 |
| Transmittance (%) | 95.56 | 95.56 | 95.61 | 95.66 | 95.67 | 95.67 | 95.67 | 95.67 | 95.78 | ≒100 |

The results shown in Tables 2 and 3 and FIGS. 4 and 5 reveal that, regardless of the type of transparent conductive film, the extinction coefficient of the transparent conductive film can be made small by controlling the ratio of the flow rate of $O_2$ gas to the flow rate of rare gas at 3 x $10^{-3}$ or more.

The results shown in Table 2 and FIG. 4 reveal that if the transparent conductive film is an ITO film, the extinction coefficient of the transparent conductive film can be further reduced by controlling the ratio of the flow rate of $O_2$ gas to the flow rate of rare gas at 4 x $10^{-3}$ or more.

The results shown in Tables 2 and 3 and FIGS. 4 and 5 reveal also that, regardless of the type of transparent conductive film, the extinction coefficient of the transparent conductive film can be still further reduced by controlling the ratio of the flow rate of $O_2$ gas to the flow rate of rare gas at 5 x $10^{-3}$ or more.

The results shown in Table 3 and FIG. 5 reveal that if the transparent conductive film is an ITiO film, the extinction coefficient of the transparent conductive film can be made particularly low by controlling the ratio of the flow rate of $O_2$ gas to the flow rate of rare gas at 10 x $10^{-3}$ or more.

The results shown in Tables 2 and 3 reveal that when the transparent conductive film is an ITiO film, the extinction coefficient thereof can be further reduced than when the transparent conductive film is an ITO film.

INDUSTRIAL APPLICABILITY

The transparent electrode of the present invention is suitable for optical communication devices using infrared light, such as tunable filters and tunable lasers.

**Claims**

1. A transparent electrode (10; 20) comprising a transparent conductive film (13), wherein the extinction coefficient of the transparent conductive film at a wavelength of 1.55 $\mu$m is equal to or less than 0.01, wherein the transparent conductive film is made of indium tin oxide or indium titanium oxide.

2. The transparent electrode of claim 1, wherein the geometric thickness of the transparent conductive film is 5 to 200 nm.

3. The transparent electrode of claim 1 or claim 2, wherein the sheet resistance of the transparent conductive film is 500 ohm/sq. or more.

4. The transparent electrode of any one of claims 1 to 3, wherein the transparent conductive film is formed on a substrate (11).

5. The transparent electrode of any one of claims 1 to 4, further comprising an antireflection film (12, 16).

6. The transparent electrode of claim 5, wherein the antireflection films (12, 16) are formed on both the front and back sides of the substrate.

7. The transparent electrode of claim 5 or 6, wherein the transparent conductive film is formed on the antireflection film formed on the front side of the substrate.

8. The transparent electrode of any one of claims 5 to 7, wherein the antireflection film is a stacked film composed of a low-refractive index layer (15; 17) and a high-refractive index layer (14; 18).

9. A method for producing the transparent electrode (10; 20) of any one of claims 1 to 8, the method comprising depositing a transparent conductive film (13) made of indium tin oxide or indium titanium oxide by use of a sputtering process in a sputtering atmosphere satisfying the condition that the ratio of the flow rate of $O_2$ gas to the flow rate of rare gas is equal to or greater than 3.0 x $10^{-3}$.

10. The method of claim 9, wherein the transparent conductive film is made of indium tin oxide and deposited by a sputtering process in an atmosphere satisfying the condition that the ratio of the flow rate of $O_2$ gas to the flow rate of rare gas is equal to or greater than 4.0 x $10^{-3}$.

11. The method of claim 9, wherein the transparent conductive film is made of indium titanium oxide and deposited by a sputtering process in an atmosphere satisfying the condition that the ratio of the flow rate of $O_2$ gas to the flow rate of rare gas is equal to or greater than 10.0 x $10^{-3}$.

**Patentansprüche**

1. Transparente Elektrode (10; 20), umfassend einen transparenten leitfähigen Film (13), wobei der Extinktionskoeffizient des transparenten leitfähigen Films bei einer Wellenlänge von 1,55 μm gleich oder kleiner als 0,01 ist, wobei der transparente leitfähige Film aus Indium-Zinn-Oxid oder Indium-Titan-Oxid gefertigt ist.

2. Transparente Elektrode nach Anspruch 1, wobei die geometrische Dicke des transparenten leitfähigen Films 5 bis 200 nm beträgt.

3. Transparente Elektrode nach Anspruch 1 oder Anspruch 2, wobei der Flächenwiderstand des transparenten leitfähigen Films 500 Ohm/sq oder mehr beträgt.

4. Transparente Elektrode nach einem der Ansprüche 1 bis 3, wobei der transparente leitfähige Film auf einem Substrat (11) ausgebildet ist.

5. Transparente Elektrode nach einem der Ansprüche 1 bis 4, ferner umfassend einen Antireflexionsfilm (12, 16).

6. Transparente Elektrode Anspruch 5, wobei der Antireflexionsfilm (12, 16) sowohl auf der Vorder- als auch auf der Rückseite des Substrats ausgebildet ist.

7. Transparente Elektrode nach Anspruch 5 oder 6, wobei der transparente leitfähige Film auf dem auf der Vorderseite des Substrats ausgebildeten Antireflexionsfilm ausgebildet ist.

8. Transparente Elektrode nach einem der Ansprüche 5 bis 7, wobei der Antireflexionsfilm ein geschichteter Film ist, der aus einer Schicht mit niedrigem Brechungsindex (15; 17) und einer Schicht mit hohem Brechungsindex (14; 18) aufgebaut ist.

9. Verfahren zur Herstellung der transparenten Elektrode (10; 20) nach einem der Ansprüche 1 bis 8, wobei das Verfahren das Abscheiden eines aus Indium-Zinn-Oxid oder Indium-Titan-Oxid gefertigten transparenten leitfähigen Films (13) unter Nutzung eines Zerstäubungsprozesses in einer Zerstäubungsatmosphäre, welche die Bedingung erfüllt, dass das Verhältnis der Durchflussmenge von $O_2$-Gas zur Durchflussmenge von Edelgas gleich oder größer als $3,0 \times 10^{-3}$ beträgt.

10. Verfahren nach Anspruch 9, wobei der transparente leitfähige Film aus Indium-Zinn-Oxid gefertigt und durch einen Zerstäubungsprozesses in einer Atmosphäre abgeschieden ist, welche die Bedingung erfüllt, dass das Verhältnis der Durchflussmenge von $O_2$-Gas zur Durchflussmenge von Edelgas gleich oder größer als $4,0 \times 10^{-3}$ beträgt.

11. Verfahren nach Anspruch 9, wobei der transparente leitfähige Film aus Indium-Titan-Oxid gefertigt und durch einen Zerstäubungsprozesses in einer Atmosphäre abgeschieden ist, welche die Bedingung erfüllt, dass das Verhältnis der Durchflussmenge von $O_2$-Gas zur Durchflussmenge von Edelgas gleich oder größer als $10,0 \times 10^{-3}$ beträgt.

**Revendications**

1. Electrode transparente (10 ; 20) comprenant un film conducteur transparent (13), où le coefficient d'extinction du film conducteur transparent à une longueur d'onde de 1,55 μm est égal ou inférieur à 0,01, où le film conducteur transparent est constitué d'oxyde d'indium-étain ou d'oxyde d'indium-titane.

2. Electrode transparente selon la revendication 1, où l'épaisseur géométrique du film conducteur transparent se situe dans l'intervalle allant de 5 à 200 nm.

3. Electrode transparente selon la revendication 1 ou 2, où la résistance de la feuille du film conducteur transparent est de 500 ohm/carré ou plus.

4. Electrode transparente selon l'une quelconque des revendications 1 à 3, où le film conducteur transparent est formé sur un substrat (11).

5. Electrode transparente selon l'une quelconque des revendications 1 à 4, comprenant en outre, un film anti-réflexion (12, 16).

6. Electrode transparente selon la revendication 5, où les films anti-réflexion (12, 16) sont formés sur les deux faces avant et arrière du substrat.

7. Electrode transparente selon la revendication 5 ou 6, où le film conducteur transparent est formé sur le film anti-réflexion formé sur la face avant du substrat.

8. Electrode transparente selon l'une quelconque des revendications 5 à 7, où le film anti-réflexion est un film empilé composé d'une couche à faible indice de réfraction (15 ; 17) et d'une couche à haut indice de réfraction (14 ; 18).

9. Procédé de production d'une électrode transparente (10 ; 20) selon l'une quelconque des revendications 1 à 8, le procédé comprenant le dépôt d'un film conducteur transparent (13) constitué d'oxyde d'indium-étain ou d'oxyde d'indium-titane par utilisation d'un processus de pulvérisation cathodique dans une atmosphère de pulvérisation satisfaisant la condition que le rapport du débit du gaz $O_2$ au débit du gaz rare est égal ou supérieur à $3,0 \times 10^{-3}$.

10. Procédé selon la revendication 9, où le film conducteur transparent est constitué d'oxyde d'indium-étain et déposé par un processus de pulvérisation cathodique dans une atmosphère satisfaisant la condition que le rapport du débit du gaz $O_2$ au débit du gaz rare est égal ou supérieur à $4,0 \times 10^{-3}$.

11. Procédé selon la revendication 9, où le film conducteur transparent est constitué d'oxyde d'indium-titane et déposé par un processus de pulvérisation cathodique dans une atmosphère satisfaisant la condition que le rapport du débit du gaz $O_2$ au débit du gaz rare est égal ou supérieur à $10,0 \times 10^{-3}$.

[FIG. 1]

[FIG. 2]

[FIG. 3]

[FIG. 4]

ITO FILM

(O₂ FLOW RATE) / (Ar FLOW RATE) (x 10⁻³)

[FIG. 5]

ITiO FILM

(O₂ FLOW RATE) / (Ar FLOW RATE) (x 10⁻³)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2000514566 A

- GB 2432222 A